# EUROPEAN PATENT SPECIFICATION

(11) **EP 1 126 952 B1**
(45) Date of publication and mention of the grant of the patent: **14.01.2004**
(21) Application number: 99950961.5
(22) Date of filing: 22.10.1999
(51) Int. Cl.: B24D 11/00, B24B 37/04, B24B 21/04

(54) **BELT FOR POLISHING SEMICONDUCTORS**
HALBLEITERPOLIERBAND
COURROIE DE POLISSAGE DE SEMI-CONDUCTEURS

(30) Priority: 26.10.1998 US 105606 P
(43) Date of publication of application: 29.08.2001
(73) Proprietor: Praxair S.T. Technology, Inc., North Haven, CT 06473 (US)
(72) Inventor: LOMBARDO, Brian, Amherst, NH 03031 (US)
(74) Representative: Phillips, Patricia Marie
(86) International application number: PCT/GB1999/003507
(87) International publication number: WO 2000/024550

(56) References cited:
- WO-A-93/12911
- WO-A-98/35785
- US-A- 1 994 283

## Description

### Background of the Invention

The purpose of this invention is to produce seamless, composite belts for improved polishing of semiconductor wafers as a result of the belts lying flat, without cupping up or down, while in contact with a semiconductor wafer.

Chemical mechanical polishing (CMP) or semiconductor wafers is a relatively new technology used in the manufacture of integrated circuits. Conventional CMP technology involves holding a wafer face down in contact with a flat polishing pad mounted on a rotating turntable. This arrangement derived from traditional glass polishing technology. More recently a new type of CMP polishing tool has been invented by Ontrak Systems, later acquired by Lam Research. The new tool, as described in U.S. Patent 5, 692,947, uses a linear polishing member comprising a conventional, flat polishing pad adhered to a supporting endless metal belt. Currently there are no one-piece belts available either for use in polishing semiconductor wafers or for use on Lam's tool.

A division of Scapa Group has been developing a seamless, composite belt for use on Lam's proprietary polishing tool. There are many difficulties and constraints involved with developing such a belt that integrally combines sufficient strength and a precision polishing surface and that can be manufactured efficiently and consistently. One unexpected problem in particular was that the prototype belts would not maintain a flat surface, i.e., the edges of the belt would curl up or down in the span between the mounting rollers, which resulted in poor polishing performance because of uneven contact with the surface of the semiconductor wafer. The present invention overcomes this critical problem.

### Summary of the Invention

In accordance with the present invention there is provided a seamless, composite belt which will maintain a substantially flat surface in a span between two spaced apart mounting surfaces; the belt comprising one or more polymer layers including a polishing layer, and one or more supporting woven or non-woven layers, wherein one or more of the layers are prestressed and/or the belt has alternating sections around its length that have opposite tendencies to cup, such that a balance between down-cupping and up-cupping forces exerted on the belt in the span between the mounting surfaces is achieved.
Belts of the present invention are particularly useful in chemical mechanical polishing of semiconductor wafers, where it is critical to maintain even contact with the entire surface of the flat wafer. In addition, belts of the present invention would be useful in other applications, including other polishing applications, printing applications, and material handling applications, for example, where uniform contact between the belt and the workpiece is necessary.

### Brief Description of the invention

The seamless, composite belts of the present invention are typically produced by casting, compression molding, or injection molding a polymer layer onto a supporting layer. The manufacturing process typically involves elevated temperatures in order to melt and flow thermoplastic materials or to combine and cure thermoset materials. However the polymeric materials may be cured at any suitable temperature or sequence of different temperatures and times as desired. The polymeric layer can be any suitable material or combination of materials. It can be solid or porous, and it may contain any types or combinations of fillers and active or inert ingredients. Typically a substantially cylindrical mold is used to produce belts with symmetrical properties and without splices or seams. The mold can be static, or it can be spinning, as in centrifugal casting. Another option for forming belts with symmetrical properties would include forming the belts on a rotating cylindrical core or roller. It is possible that the belts could be manufactured by a continuous extrusion of a polymer layer onto a tubular support material that is then sliced into belts of a desired width.

A composite belt of at least two different layers typically is needed to provide both the precision polishing surface and the necessary mechanical strength of the belt. The polishing layer can be smooth or textured and can have any suitable pattern of grooves, depressions, or raised features, that have been molded in or achieved by machining or other secondary operations. The supporting layers may be any type of woven or non-woven fabric, made of natural or synthetic, organic or inorganic materials.

However, the composite structure can lead to uneven internal stresses when the belt is at rest and when it is mounted on rollers under tension, which often result in the edges of the belt cupping up or down in the span between the mounting rollers. Often the uneven internal stresses are caused by the use of materials with different thermal or molecular shrinkage rates or different tensile, shear, and compressive properties. Given this understanding of the potential causes of belt cupping, it would seem logical to look for a way to totally eliminate the uneven internal stresses either by matching properties of different materials or by finding a single material that both polishes and provides mechanical strength. However, a single component belt that is seamless and that has been formed in a substantially cylindrical shape, for example a solid rubber or urethane belt, will not lie perfectly flat in the span between the mounting rollers, and in fact the edges will cup downward. A surprising feature of this invention is that the belts must have a composite structure in order for the seamless polishing belts to provide the flat surface in the span where the wafers are contacted.

The composite structure is necessary in order to provide the right balance of up-cupping and down-cupping forces in the belt when spanned between mounting rollers. Balancing the up-cupping and the down-cupping forces can be achieved by prestressing one or more of the composite layers. In addition it is possible to create a suitable balance between up-cupping and down-cupping by forming a belt with alternating sections around the length of the belt that have opposite tendencies to cup. The alternating up-cupping and down-cupping sections tend to cancel each other out to force the belt to lie substantial flat throughout the span between the mounting rollers.

Examples of belt structures that have the desired balance of up-cupping and down-cupping in order to lie flat include
1) A three-layer belt where a woven fabric is coated on both sides by hot cast polyurethane and where the top layer of urethane is thicker than the bottom layer.
2) A two-layer belt where a loosely woven, mesh fabric is coated on the outside or top by hot cast polyurethane.
3) A two-layer belt where a hot cast polyurethane layer is formed with wound reinforcing cord.
4) A two-layer belt where the hot cast polyurethane layer is formed over a prestressed fabric being held under tension during the molding process.
5) A two-layer belt where a fabric layer is coated with a polyurethane layer that is allowed to solidify at room temperature before completing the cure cycle at a higher temperature.
6) A three-layer belt where the top and bottom layers are the same thickness but the top layer is made of a more rigid material than the bottom layer.
7) A three-layer belt where the top layer is a uniform thickness but the bottom layer varies in the thickness sinusoidally so as to create alternating sections with slight up-cupping and slight down-cupping tendencies.
8) A three-layer belt where the top layer is a foam and the bottom layer is a solid material.

## Claims

1. A seamless, composite belt which will maintain a substantially flat surface in a span between two spaced apart mounting surfaces: the belt comprising one or more polymer layers including a polishing layer, and one or more supporting woven or non-woven layers, **characterised in that** one or more of the layers are prestressed and/or the belt has alternating sections around its length that have opposite tendencies to cup, such that a balance between up-cupping and down-cupping forces exerted on the belt in the span between the mounting surfaces is achieved.

2. The belt of claim 1 wherein the belt is in substantially cylindrical shape.

3. The belt of claim 1 or 2 wherein the belt is a three-layer belt having a woven fabric layer coated on both sides by hot cast polyurethane to form a top and a bottom polymer layer and wherein the top layer of urethane is thicker than the bottom layer.

4. The belt of claim 1 or 2 wherein the belt is a two-layer belt having a loosely woven, mesh fabric layer coated with a hot cast polyurethane layer.

5. The belt of claim 1 or 2 wherein the belt is a two-layer belt having a hot cast polyurethane layer formed with wound reinforcing cord.

6. The belt of claim 1 or 2 wherein the belt is a two-layer belt having a hot cast polyurethane layer formed over a prestressed fabric layer held under tension during a molding process.

7. The belt of claim 1 or 2 wherein the belt is a two-layer belt having a fabric layer coated with a polyurethane layer that is allowed to solidify at room temperature before completing a cure cycle at a higher temperature.

8. The belt of claim 1 or 2 wherein the belt is a three-layer belt having top and bottom polymer layers of the same thickness on either side of the supporting layer, and having the top polymer layer made of a more rigid material than the bottom polymer layer.

9. The belt of claim 1 or 2 wherein the belt is a three-layer belt having a top polymer layer of a uniform thickness above the supporting layer and a bottom polymer layer below the supporting layer which varies in thickness sinusoidally so as to create alternating sections with slight up-cupping and slight down-cupping tendencies.

10. The belt of claim 1 or 2 wherein the belt is a three-layer belt having a supporting layer sandwiched between top and bottom layers, and wherein the top polymer layer is formed from a polymer foam and the bottom polymer layer is formed from a solid polymer.

11. A chemical mechanical polishing tool for the polishing of silicon or semiconductor wafers comprising a belt as claimed in any one of claims 1 to 10.

## Patentansprüche

1. Verbundstoffband ohne Verbindungsnaht, das in einem Bereich zwischen zwei auf Abstand liegenden Montageflächen eine im wesentlichen flache Oberfläche beibehält, wobei das Band eine oder mehrere polymere Schichten einschließlich einer Polierschicht sowie eine oder mehrere gewebte oder nichtgewebte Stützschichten umfaßt, **dadurch gekennzeichnet, daß** eine oder mehrere der Schichten vorgespannt sind und/oder das Band über seine Länge wechselnde Abschnitte aufweist, die entgegengesetzte Wölbungstendenzen aufweisen, so daß zwischen nach oben wölbenden und nach unten wölbenden Kräften, die in dem Bereich zwischen den Montageflächen auf das Band ausgeübt werden, ein Gleichgewicht erzielt wird.

2. Band nach Anspruch 1,
wobei das Band im wesentlichen von zylindrischer Form ist.

3. Band nach Anspruch 1 oder 2,
wobei das Band ein dreischichtiges Band mit einer Gewebeschicht ist, die zur Bildung einer oberen und einer unteren polymeren Schicht auf beiden Seiten mit warmgegossenem Polyurethan beschichtet ist, und wobei die obere Schicht aus Urethan dicker ist als die untere Schicht.

4. Band nach Anspruch 1 oder 2,
wobei das Band ein zweischichtiges Band mit einer locker gewebten Netzgewebe-Schicht ist, die mit einer warmgegossenen Polyurethanschicht beschichtet ist.

5. Band nach Anspruch 1 oder 2,
wobei das Band ein zweischichtiges Band mit einer warmgegossenen Polyurethanschicht ist, die einen gewundenen Verstärkungsfaden aufweist.

6. Band nach Anspruch 1 oder 2,
wobei das Band ein zweischichtiges Band mit einer warmgegossenen Polyurethanschicht ist, die über einer vorgespannten Gewebeschicht ausgebildet wird, welche während eines Formverfahrens unter Spannung gehalten wird.

7. Band nach Anspruch 1 oder 2,
wobei das Band ein zweischichtiges Band mit einer Gewebeschicht ist, die mit einer Polyurethanschicht beschichtet ist, welche sich bei Raumtemperatur verfestigen kann, bevor ein Härtungszyklus bei höherer Temperatur beendet wird.

8. Band nach Anspruch 1 oder 2,
wobei das Band ein dreischichtiges Band ist, das eine obere und eine untere polymere Schicht derselben Dicke auf beiden Seiten der Stützschicht aufweist, und bei dem die obere polymere Schicht aus einem härteren Material besteht als die untere polymere Schicht.

9. Band nach Anspruch 1 oder 2,
wobei das Band ein dreischichtiges Band ist, das eine obere polymere Schicht von gleichmäßiger Dicke über der Stützschicht und eine untere polymere Schicht unter der Stützschicht aufweist, deren Dicke sich sinusförmig ändert, so daß wechselnde Abschnitte mit sich leicht nach oben wölbenden und sich leicht nach unten wölbenden Tendenzen gebildet sind.

10. Band nach Anspruch 1 oder 2,
wobei das Band ein dreischichtiges Band mit einer Stützschicht ist, die zwischen einer oberen und einer unteren Schicht angeordnet ist, und wobei die obere polymere Schicht aus einem polymeren Schaum und die untere polymere Schicht aus einem festen Polymer gebildet ist.

11. Chemisch-mechanisches Polierwerkzeug zum Polieren von Silicium- oder Halbleiterwafern mit einem Band nach einem der Ansprüche 1 bis 10.

## Revendications

1. Courroie composite sans couture qui maintient une surface sensiblement plate dans un intervalle entre deux surfaces de montage espacées ; la courroie comprenant une ou plusieurs couches polymères comprenant une couche de polissage, et une ou plusieurs couches tissées ou non tissées de support, **caractérisée en ce que** la ou les couche(s) est (sont) précontrainte(s) et / ou la courroie présente des sections alternées autour de sa longueur qui ont des tendances opposées à l'évasement, de telle sorte qu'on réalise un équilibre entre les forces d'évasement vers le haut et les forces d'évasement vers le bas exercées sur la courroie dans l'intervalle entre les surfaces de montage.

2. Courroie selon la revendication 1, qui présente une forme sensiblement cylindrique.

3. Courroie selon la revendication 1 ou 2, qui est une courroie à trois couches présentant une couche de tissu tissée, revêtue sur les deux faces par du polyuréthanne coulé à chaud, pour former une couche polymère supérieure et une couche polymère inférieure, et dont la couche supérieure d'uréthanne est plus épaisse que la couche inférieure.

4. Courroie selon la revendication 1 ou 2, qui est une courroie à deux couches présentant une couche de tissu à mailles lâche revêtue d'une couche de polyuréthanne coulé à chaud.

5. Courroie selon la revendication 1 ou 2, qui est une courroie à deux couches présentant une couche de polyuréthanne coulé à chaud formée avec un cordon de renforcement enroulé.

6. Courroie selon la revendication 1 ou 2, qui est une courroie à deux couches présentant une couche de polyuréthanne coulé à chaud formée sur une couche de tissu précontraint maintenu sous tension durant un processus de moulage.

7. Courroie selon la revendication 1 ou 2, qui est une courroie à deux couches présentant une couche de tissu revêtue d'une couche de polyuréthanne qu'on laisse se solidifier à température ambiante avant d'entreprendre un cycle de durcissement à une température plus élevée.

8. Courroie selon la revendication 1 ou 2, qui est une courroie à trois couches présentant des couches polymères supérieure et inférieure de la même épaisseur sur chaque côté de la couche de support, et dont la couche polymère supérieure est réalisée dans un matériau plus rigide que la couche polymère inférieure.

9. Courroie selon la revendication 1 ou 2, qui est une courroie à trois couches présentant une couche polymère supérieure d'une épaisseur uniforme au-dessus de la couche de support et une couche polymère inférieure en dessous de la couche de support dont l'épaisseur varie de manière sinusoïdale pour créer des sections alternées avec des tendances légères à l'évasement vers le haut et des tendances légères à l'évasement vers le bas.

10. Courroie selon la revendication 1 ou 2, qui est une courroie à trois couches présentant une couche de support intercalée entre les couches supérieure et inférieure, et dont la couche polymère supérieure est formée à partir d'une mousse polymère et dont la couche inférieure est réalisée à partir d'un polymère solide.

11. Outil de polissage mécanique et chimique pour polir des tranches de silicium ou semi-conducteurs, comprenant une courroie selon l'une quelconque des revendications 1 à 10.
